# EUROPEAN PATENT APPLICATION

(11) **EP 4 482 283 A1**
(43) Date of publication of application: **25.12.2024**
(21) Application number: 23180640.7
(22) Date of filing: 21.06.2023
(51) Int. Cl.: H10N 60/01, H10N 60/12, H10N 69/00

(54) **QUBIT DEVICE, METHOD FOR FABRICATING THE QUBIT DEVICE, AND CONTACT LAYER FOR THE METHOD**

(71) Applicant: Terra Quantum AG, 9000 St. Gallen (CH); Leibniz-Institut für Festkörper- und Werkstoffforschung Dresden e.V., 01069 Dresden (DE)
(72) Inventor: Brosco, Valentina, 9000 St. Gallen (CH); Vinokour, Valerii, 9000 St. Gallen (CH); Poccia, Nicola, 9000 St. Gallen (CH); Vool, Uri, 9000 St. Gallen (CH)
(74) Representative: Kretschmann, Dennis

(57) **Abstract**

A qubit device (100) comprises a first and second superconductor layer (102a and 102b), a capacitor (132), and a first and second interconnect (108a and 108b). The first and second superconductor layer comprise respectively a first and second superconductor material. The first superconductor material is a first anisotropic, layered material with covalently bound atomic layers and a first c-axes perpendicular to the covalently bound atomic layers of the first superconductor material. The second superconductor material is a second anisotropic, layered material with covalently bound atomic layers (126) and a second c-axes perpendicular to the covalently bound atomic layers of the second superconductor material. The second superconductor layer is arranged over the first superconductor layer to form a Josephson junction (120) between the first and second superconductor material, wherein the first and second c-axis are aligned with each other at the Josephson junction; and wherein the aligned first and second c-axes at the Josephson junction intersect both the first and second superconductor layer. The capacitor comprises a first and second electrode (130a and 130b). The first interconnect electrically connects the first electrode and the first superconductor layer. The second interconnect electrically connects the second electrode and the second superconductor layer. The capacitor is arranged at a vertical position exceeding the vertical positions of both the first and second superconductor layer.

## Description

### TECHNICAL FIELD

The disclosure relates to a qubit device employing a high-Tc superconductor, such as a d-wave superconductor, and, in particular, relates to a qubit device similar to the transmon type.

### BACKGROUND

The modern microelectronics industry is experiencing rapid growth with the trend towards extensive use of qubits which provide the basis for quantum computing. Quantum computing has attracted much attention over the last years, partly because of its promise of super-fast factoring and its potential for the efficient simulation of quantum dynamics. There are many different architectures for quantum computers based on different physical systems to implement the qubit. These include atom- and ion-trap quantum computing, superconducting charge and flux qubits, nuclear magnetic resonance, spin- and charge-based quantum dots, nuclear spin quantum computing, and optical quantum computing. All these systems have their own advantages in quantum information processing. However, even though there may now be a few front-runners, such as ion-trap and superconducting quantum computing, no physical implementation seems to have a clear edge over others at this point.

A conventional superconducting qubit device comprises a Josephson junction between low-temperature superconductor materials such as Al or Nb. The qubit device can be flexibly designed to match necessary parameters. Its macroscopic size allows for strong coupling, leading to fast gates and measurement. The transmon superconducting qubit is the most common hardware implementation of quantum technology, and it is used in conventional superconducting quantum processors, such as the ones developed by Google or IBM. The main weakness of the transmon is its coupling to electric fields in the capacitor, leading to reduced coherence times and crosstalk between qubits - and thus errors in the computation.

The coherence time of such conventional superconductor-based qubits comprising a Josephson junction between low-temperature superconductor materials approaches a millisecond. However, despite their high quality, qubits based on low-temperature superconductors have intrinsic limitations. For example, those qubits are strongly affected by magnetic fields because of the intrinsic superconducting properties of the low-temperature superconductor, such as its small superconducting gap, and its critical temperature that is very low, about 1K.

Superconducting qubits using high-temperature superconductors hold the potential to overcome some of those limitations. However, the actual physical implementation of a qubit using a high-temperature superconductor Josephson junction is technologically challenging, as for those materials, unlike for low-temperature superconductors such as Al or Nb, lithographic structuring or deposition techniques are to date not available. When the lithographic structuring or deposition techniques used in the fabrication of conventional qubit devices are applied to the high-temperature superconductor, they cause significant densities of defects therein, and decomposition of the high-temperature superconductor material.

WO 2022/197482 A1 describes a qubit of the transmon type, wherein conductive layers of a capacitor are composed of van der Waals materials.

### OVERVIEW

In view of the technical problems laid out above, there is a need for an improved qubit. This problem is solved by a qubit device according to claim 1, a method for fabricating a qubit device according to claim 9, and by a contact layer for fabricating a qubit device according to claim 15. The dependent claims relate to preferred embodiments.

In a first aspect, a qubit device comprises a first superconductor layer, a second superconductor layer, a capacitor, a first interconnect and a second interconnect. The first superconductor layer comprises a first superconductor material. The first superconductor material is a first anisotropic, layered material with covalently bound atomic layers and a first c-axes perpendicular to the covalently bound atomic layers of the first superconductor material. The second superconductor layer comprises a second superconductor material. The second superconductor material is a second anisotropic, layered material with covalently bound atomic layers and a second c-axes perpendicular to the covalently bound atomic layers of the second superconductor material. The second superconductor layer is arranged over the first superconductor layer to form a Josephson junction between the first superconductor material and the second superconductor material. The first c-axis and the second c-axis are aligned with each other at the Josephson junction. The aligned first and second c-axes at the Josephson junction intersect both the first superconductor layer and the second superconductor layer. The capacitor comprises a first electrode and a second electrode. The first interconnect electrically connects the first electrode and the first superconductor layer. The second interconnect electrically connects the second electrode and the second superconductor layer. The capacitor is arranged at a vertical position exceeding the vertical positions of both the first superconductor layer and the second superconductor layer.

This structure permits to design and provide the Josephson junction independently of the capacitor and vice versa. Consequently, a fully optimized qubit device is provided. As compared to low-temperature superconductor materials, the superconductor layers comprising anisotropic, layered materials may suffer from variations during fabrication (e.g., with respect to their sizes or shapes). It is an advantage of the qubit device of this description, that variations in the fabrication of the superconductor layer(s) (and/or of the Josephson junction, respectively) do not translate into variations of the capacitor; to the contrary, they can be compensated by a tailored design of the capacitor. The capacitor may be fabricated using conventional lithographic structuring or deposition techniques, providing a high structural accuracy.

The structure is an immediate consequence of implementing the fabrication technique, or of the provision of the contact layer, respectively, which will be described in detail below. The resulting structure, i.e., the (first and second) superconductor material(s), has/have a significantly lower defect density than structures, which are fabricated using lithographic structuring or deposition techniques, or, than the (high-critical-temperature) superconductor material(s) therein, respectively.

The Josephson junction may be referred to as a van der Waals Josephson junction, in particular, in embodiments, wherein the first and/or the second superconductor material is/are van der Waals materials.

The first and/or the second anisotropic, layered material may be a cleavable material, such as a material cleavable using an adhesive tape.

The first superconductor layer may be composed of the first superconductor material.

The second superconductor layer may be composed of the second superconductor material.

The first c-axis may refer to a unique crystallographic axis of the first superconductor material.

The second c-axis may refer to a unique crystallographic axis of the second superconductor material.

The first and/or the second superconductor material may comprise a layered atomic structure and/or crystallographic structure. The first (and/or the second) c-axis may be perpendicular to covalently bound layers and/or to van der Waals gaps of the layered atomic and/or crystallographic structure of the first (and/or the second) superconductor material.

The first and/or the second superconductor material may be van der Waals materials.Any of the anisotropic, layered materials may be isotropic at the atomic scale and/or with respect to its electronic, optical, and/or mechanical properties, for example when in a monocrystalline form.

The capacitor may be arranged above the Josephson junction.

A vertical line may intersect both the first superconductor layer and the first electrode.

A vertical line may intersect both the second superconductor layer and the second electrode.

The qubit device may further comprise an electrical insulation element.

The electrical insulation element may be arranged at a vertical position between the vertical position of the capacitor and the vertical position(s) of the first superconductor layer and/or of the second superconductor layer.

A respective electrical insulation element ensures that the second superconductor layer and the first electrode are electrically insulated from each other, and/or that the first superconductor layer and the second electrode are electrically insulated from each other. Moreover, the electrical insulation element provides a matrix for the first and/or the second interconnect.

The electrical insulation element may be arranged between the first superconductor layer and the second electrode.

The electrical insulation element may be arranged between the second superconductor layer and the first electrode.

The electrical insulation element may be arranged between the first superconductor layer and the first electrode.

The electrical insulation element may be arranged between the second superconductor layer and the second electrode.

At least a section of the first interconnect may be arranged in the electrical insulation element.

The first interconnect may be arranged in the electrical insulation element.

At least a section of the second interconnect may be arranged in the electrical insulation element.

The second interconnect may be arranged in the electrical insulation element.

The first interconnect and/or the second interconnect may extend through the electrical insulation element, and, optionally, from a bottom surface thereof to a top surface thereof.

The electrical insulation element may comprise or be composed of silicon carbide, silicon nitride, or amorphous silicon.

Respective materials provide sufficient electrical insulation. Moreover, they are mechanically flexible when provided as sufficiently thin layers (e.g., no more than 600 nm), which is beneficial for the fabrication of a respective qubit device.

A lateral extension of the electrical insulation element may fully cover a lateral extension of the first superconductor layer and a lateral extension of the second superconductor layer.

In respective embodiments, the electrical insulation element also provides mechanical protection for the first superconductor layer and/or for the second superconductor layer, and, in some embodiments, a sealing, e.g., against moisture or reactive gases such as oxygen.

The electrical insulation element may have a thickness along the vertical direction in a range from 300 nm to 600 nm.

The qubit device may further comprise an encapsulation of the Josephson junction, such as a water-tight, a moisture-tight, an oxygen-tight and/or an air-tight encapsulation, wherein the encapsulation comprises the electrical insulation element and, optionally, a substrate over which the Josephson junction is arranged.

The first superconductor material may comprise a first orientation parallel to its covalently bound atomic layers. The second superconductor material may comprise a second orientation parallel to its covalently bound atomic layers. The first superconductor material and the second superconductor material at the Josephson junction may be arranged with an angle between the first orientation and the second orientation corresponding to a predefined angle.

The device parameters of the qubit device may be tailored to the needs of a specific device application using the angle between the orientations of the superconductor materials. For example, a qubit device with a particularly long coherence time may be provided by adjusting the respective angle.

The first superconductor material and the second superconductor material at the Josephson junction may be arranged with an angle between the first orientation and the second orientation in a range from 38 to 44.9°.

A respective angle maximizes the coherence time of the qubit device, in particular for superconductor materials with an angle of approximately 90° between their horizontal, primitive lattice vectors, such as BSCCO (i.e., Bi₂Sr₂Caₙ₋₁CuₙO2ₙ₊₄₊ₓ).

The first c-axis may correspond to a primitive lattice vector of the first superconductor material.

The second c-axis may correspond to a primitive lattice vector of the second superconductor material.

The first orientation may correspond to a first primitive lattice vector perpendicular to the first c-axis, in particular, to a direction of the first primitive lattice vector perpendicular to the first c-axis.

The second orientation may correspond to a second primitive lattice vector perpendicular to the second c-axis, in particular, to a direction of the second primitive lattice vector perpendicular to the first c-axis.

The covalently bound atomic layers of the first superconductor material and/or of the second superconductor material may be separated by van der Waals gaps.

The first orientation may correspond to a lattice vector of the first superconductor material parallel to the covalently bound atomic layers of the first superconductor material, and the second orientation may correspond to a corresponding lattice vector of the second superconductor material parallel to the covalently bound atomic layers of the second superconductor material.

The first orientation may refer to a direction of a node in a d-wave electronic spectrum of the respective superconductor material.

The first superconductor material and the second superconductor material may have a same crystallographic structure and/or a same crystallographic unit cell and/or be a same superconductor material.

The first superconductor material and/or the second superconductor material may be a high-temperature superconductor material, in particular, with a critical temperature of at least 4 K or at least 8 K or at least 15 K or at least 30 K or at least 50 K or at least 70 K or at least 78 K.

The first superconductor material and/or the second superconductor material may be a type-II superconductor material.

The first superconductor material and/or the second superconductor material may be a d-wave superconductor material.

The first superconductor material and/or the second superconductor material may comprise oxygen or a chalcogenide, in particular to at least 20 atomic percent or at least 30 atomic percent.

The first superconductor material and/or the second superconductor material may comprise a chemical composition Bi₂Sr₂Caₙ₋₁CuₙO₂ₙ₊₄₊ₓ, in particular, wherein n = 1 or 2 or 3 or 4.

A distance between the first superconductor material and the second superconductor material at the Josephson junction may be at least 0.2 nm, in particular at least 0.25 nm, in particular at least 0.3 nm, in particular at least 0.35 nm, in particular at least 0.4 nm, in particular at least 0.45 nm, or at least 0.5 nm.

A distance between the first superconductor material and the second superconductor material at the Josephson junction may be at most 10 nm, in particular at most 8 nm, in particular at most 6 nm, in particular at most 4 nm, in particular at most 3 nm, in particular at most 2 nm, in particular at most 1 nm.

A spacer material may be arranged between the first superconductor material and the second superconductor material at the Josephson junction, wherein, optionally, the spacer material comprises or is composed of an anisotropic layered material.

The spacer material may help to ensure the correct distance between the superconductor materials at the Josephson junction.

An area of an overlap region between the first superconductor material and the second superconductor material at the Josephson junction may be at least 0.1 µm², in particular at least 0.3 µm², in particular at least 0.5 µm², or at least 1 µm².

An area of an overlap region between the first superconductor material and the second superconductor material at the Josephson junction may be at most 50 µm² or at most 1 µm².

The qubit device may further comprise a microwave resonator.

A respective microwave resonator facilitates the readout of the qubit device, for example in the form of a dispersive readout.

The microwave resonator may be capacitively coupled to the capacitor, optionally, along a horizontal direction.

The microwave resonator may be arranged at a vertical position exceeding the vertical positions of both the first superconductor layer and the second superconductor layer.

A respective microwave resonator may beneficially be fabricated in a same process step together with the capacitor, such that the respective qubit device can be fabricated in few steps and therefore efficiently and economically.

The microwave resonator may comprise or be composed of a superconductor material, such as a low-temperature superconductor material or an elemental or nitride superconductor material, such as Al, Nb, NbN, or TiN.

A respective choice of materials facilitates the fabrication of the respective component(s) using conventional lithographic structuring or deposition techniques, and thus improves the structural accuracy during fabrication.

A resonance frequency of the microwave resonator may be in a range from 1 GHz to 10 GHz, or in a range from 1 GHz to 10 GHz.

A capacitance of the capacitor may be in a range from 4 femtofarads to 500 femtofarads, or in a range from 4 femtofarads to 400 femtofarads, or in a range from 70 femtofarads to 400 femtofarads.

The first electrode and/or the second electrode and/or the first interconnect and/or the second interconnect may comprise or be composed of a superconductor material, such as a low-temperature superconductor material or an elemental or nitride superconductor material, such as Al, Nb, NbN, or TiN.

In a second aspect, a method for fabricating a qubit device comprises providing a Josephson junction between a first superconductor material and a second superconductor material; and providing a contact layer separate from the Josephson junction. The contact layer comprises an electrical insulation element, a first interconnect, and a second interconnect. The first interconnect extends through the electrical insulation element. The second interconnect extends through the electrical insulation element. The method further comprises arranging the contact layer over the Josephson junction to form an electrical contact between the first interconnect and the first superconductor material and to form an electrical contact between the second interconnect and the second superconductor material.

This fabrication method, by providing the contact layer separate from the Josephson junction and arranging it thereover at a later step, ensures minimum damage to the Josephson junction, or to the first and second superconductor material(s), respectively, during fabrication.

The contact layer provided separate from the Josephson junction may comprise a capacitor arranged over the electrical insulation element. Said capacitor may comprise a first electrode and a second electrode In corresponding embodiments, the first interconnect may be electrically connected to the first electrode and/or the second interconnect may be electrically connected to the second electrode.

The contact layer provided separate from the Josephson junction may comprise a microwave resonator arranged over the electrical insulation element, wherein, optionally, the microwave resonator is capacitively coupled to the capacitor.

The method may further comprise cooling the Josephson junction to a temperature below a first temperature while the contact layer is arranged over the Josephson junction, wherein the first temperature is 0°C, or 250 K, or 230 K, or 210 K, or 190 K, or 170 K, or 150 K, or 130 K.

The cooling further reduces any damage to the Josephson junction, or to the first and second superconductor material(s), respectively, during fabrication.

The arranging the contact layer over the Josephson junction may comprise attaching a transfer device to the contact layer; and cooling the transfer device to a temperature below a second temperature to attach the transfer device to the contact layer. The transfer device may be adapted to provide a strong adhesion when a temperature of the transfer device is below the second temperature and to provide a weak adhesion when the temperature of the transfer device is above the second temperature, or above a third temperature exceeding the second temperature.

The respective transfer device permits to reliably pick up and to place the contact layer at a reduced (i.e., below the first temperature) fabrication temperature.

The transfer device may comprise or be composed of an elastomer.

The second temperature and/or the third temperature may exceed a glass transition temperature of the elastomer.

The third temperature may correspond to the glass transition temperature of the elastomer.

The elastomer may be PTFE or PDMS.

The second temperature may be no larger than the first temperature.

The arranging the contact layer over the Josephson junction may comprise releasing the transfer device from the contact layer, wherein the releasing the transfer device from the contact layer comprises heating the transfer device to a temperature between the second temperature and the first temperature. The respective temperature may exceed a third temperature, the third temperature exceeding both the first temperature and the second temperature.

The first superconductor material may be a first anisotropic, layered material with covalently bound atomic layers and a first c-axes perpendicular to the covalently bound atomic layers of the first superconductor material. The second superconductor material may be a second anisotropic, layered material with covalently bound atomic layers and a second c-axes perpendicular to the covalently bound atomic layers of the second superconductor material.

In respective embodiments, the Josephson junction may be provided such that the first c-axis and the second c-axis are aligned with each other at the Josephson junction, and/or may be provided such that both the first and second c-axes at the Josephson junction intersect both the first superconductor material and the second superconductor material.

The providing the Josephson junction between the first superconductor material and the second superconductor material may comprise arranging a first superconductor layer of the first anisotropic, layered material over a substrate; and arranging a second superconductor layer of the second anisotropic, layered material over the first superconductor layer to generate the Josephson junction.

The providing the Josephson junction between the first superconductor material and the second superconductor material may comprise, prior to the arranging the first superconductor layer and the second superconductor layer, cleaving the first anisotropic, layered material to generate the first superconductor layer and/or cleaving the second anisotropic, layered material to generate the second superconductor layer, and, optionally, keeping the first anisotropic, layered material at a temperature below the first temperature while cleaving it and/or keeping the second anisotropic, layered material at a temperature below the first temperature while cleaving it.

The cleaving the first anisotropic, layered material and/or the cleaving the second anisotropic, layered material and/or the arranging the first superconductor layer over the substrate and/or the arranging the second superconductor layer over the first superconductor layer may be performed using a transfer device comprising or composed of an elastomer.

The electrical insulation element may be provided with a sufficiently small thickness to be mechanically flexible, such as with a thickness of 300 nm to 600 nm.

According to a third aspect, a contact layer for fabricating a qubit device comprises an electrical insulation element, a capacitor, a first interconnect, and a second interconnect. The capacitor comprises a first electrode and a second electrode arranged over the electrical insulation element. The first interconnect is electrically connected to the first electrode and extends through the electrical insulation element from a bottom surface thereof to a top surface thereof. The second interconnect is electrically connected to the second electrode and extends through the electrical insulation element from the bottom surface thereof to the top surface thereof. Each of the first electrode, the second electrode, the first interconnect, and the second interconnect comprise(s) a respective superconductor material.

The electrical insulation element may comprise a sufficiently small thickness to be mechanically flexible, such as a thickness of 300 nm to 600 nm.

The contact layer may comprise a microwave resonator arranged over the electrical insulation element, wherein, optionally, the microwave resonator is capacitively coupled to the capacitor.

According to a further aspect, a method for changing a state of a qubit device comprises: Coupling a first microwave with a first microwave frequency to the qubit device, wherein the first microwave frequency is associated with an energy difference between a third excited state and a ground state of the qubit device; coupling a second microwave with a second microwave frequency to the qubit device, wherein the second microwave frequency is associated with an energy difference between a third excited state and a second excited state of the qubit device; and coupling a third microwave with a third microwave frequency to the qubit device, wherein the third microwave frequency is associated with an energy difference between a second excited state and a first excited state of the qubit device.

This method permits to reliably change the state of the qubit device, even if a transition between the ground state and the first excited state of the qubit device has a very low transition probability, or even if the ground state and the first excited state are (almost) degenerate.

According to an embodiment, the first microwave frequency is mismatched to the energy difference between the third excited state and the ground state of the qubit device, for example by at least 0.01 percent and at most by 5 percent. Alternatively, or in addition, the second microwave frequency may be mismatched to the energy difference between the third excited state and the second excited state of the qubit device, for example by at least 0.01 percent and at most by 5 percent. Alternatively, or in addition, the third microwave frequency may be mismatched to the energy difference between the second excited state and the first excited state of the qubit device, for example by at least 0.01 percent and at most by 5 percent. In corresponding embodiments, the first microwave, the second microwave, and the third microwave may be coupled to the qubit device at the same time.

According to another embodiment, the method comprises first coupling the first microwave and the third microwave to the qubit device (wherein, optionally, the first microwave and the third microwave may be coupled to the qubit device as pi-pulses), then coupling the second microwave to the qubit device (wherein, optionally, the second microwave may be coupled to the qubit device according to a predefined phase difference between the ground state and the first excited state), and then coupling the first microwave and the third microwave to the qubit device (wherein, optionally, the first microwave and the third microwave may be coupled to the qubit device as pi-pulses). In corresponding embodiments, the first microwave frequency may be matched to the energy difference between the third excited state and the ground state of the qubit device, for example within 0.01 percent. Alternatively, or in addition, the second microwave frequency may be matched to the energy difference between the third excited state and the second excited state of the qubit device, for example within 0.01 percent. Alternatively, or in addition, the third microwave frequency may be matched to the energy difference between the second excited state and the first excited state of the qubit device, for example within 0.01 percent.

The qubit device may be a qubit device according to any of the embodiments described above.

The first microwave frequency may be in a range from 7 GHz to 15 GHz.

The second microwave frequency may be in a range from 1 GHz to 2 GHz.

The third microwave frequency may be in a range from 6 GHz to 13 GHz.

The method may further comprise analyzing the changed state of the qubit using a dispersive readout.

The coupling the first, second, and/or third microwave to the qubit device and/or the dispersive readout may use the microwave resonator described above.

### BRIEF DESCRIPTION OF THE FIGURES

The techniques of the present disclosure and the advantages associated therewith will be best apparent from a description of exemplary embodiments in accordance with the accompanying drawings, in which:
- Fig. 1: gives a cross-sectional view of a qubit device according to an embodiment;
- Fig. 2a: gives a cross-sectional view of a qubit device according to another embodiment;
- Fig. 2b: gives a cross-sectional view of a qubit device according to another embodiment;
- Fig. 2c: gives a cross-sectional view of a qubit device according to another embodiment;
- Fig. 3: gives a top view of a qubit device according to another embodiment;
- Fig. 4a: gives a perspective view of a qubit device according to another embodiment;
- Fig. 4b: gives a cross-sectional view of the qubit device of Fig. 4a;
- Fig. 5a: illustrates a second superconductor layer arranged over a first superconductor layer to form a Josephson junction, according to a perspective view;
- Fig. 5b: illustrates the second superconductor layer arranged over the first superconductor layer according to Fig. 5a, according to a top view;
- Fig. 6: illustrates a method for forming a qubit device;
- Fig. 7: illustrates process steps for providing a contact layer;
- Fig. 8: gives a cross-sectional view of a contact layer according to an embodiment;
- Fig. 9: illustrates process steps for arranging a second superconductor layer over a first superconductor layer to form a Josephson junction;
- Fig. 10: illustrates a method for changing a state of a qubit device according to an embodiment; and
- Fig. 11: illustrates a method for changing a state of a qubit device according to another embodiment.

### DETAILED DESCRIPTION

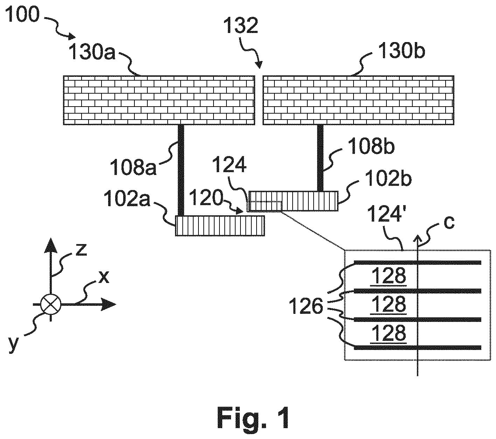

Fig. 1 gives a cross-sectional view of a qubit device 100 according to a first embodiment.

The qubit device 100 comprises a first superconductor layer 102a. It further comprises a second superconductor layer 102b arranged over the first superconductor layer 102a to form a Josephson junction 120.

The first superconductor layer 102a and the second superconductor layer 102b comprise respective superconductor materials. Those superconductor materials are anisotropic, layered materials, as is typical for high-critical-temperature superconductor materials, or for d-wave superconductor materials, respectively.

Thicknesses of the superconductor layers 102a, 102b are typically in the range from 30 nm to 90 nm.

The closeup 124' illustrates an anisotropic, layered material. It gives a close-up of the structure of the second superconductor layer 102b in the region 124. A distance between the covalently bound atomic layers 126 in the closeup 124' corresponds to 1 to 5 nm, depending on the specific superconductor material. The covalently bound atomic layers 126 of the second superconductor material are separated from each other by van der Waals gaps 128. The axis c is perpendicular to the covalently bound atomic layers 126, or to the van der Waals gaps 128, respectively.

In the closeup 124', the structure of the second superconductor material of the second superconductor layer 102b is illustrated. However, the first superconductor material of the first superconductor layer 102a has a similar structure with covalently bound atomic layers 128 and van der Waals gaps 126.

Examples for respective anisotropic, layered superconductor materials are cuprates such as BSCCO (i.e., Bi₂Sr₂Caₙ₋₁CuₙO₂ₙ₊₄₊ₓ where n = 2, 3, 4), or iron based high temperature superconductors (e.g., FeSe, potassium doped FeSe, FeSexTe1-x).

Further, a capacitor 132 is arranged above the first and the second superconductor layers 102a, 102b, i.e., at a position along the vertical direction z exceeding the respective positions of the first and the second superconductor layers 102a.

The capacitor 132 comprises two electrodes 130a, 130b arranged in vicinity of one another.

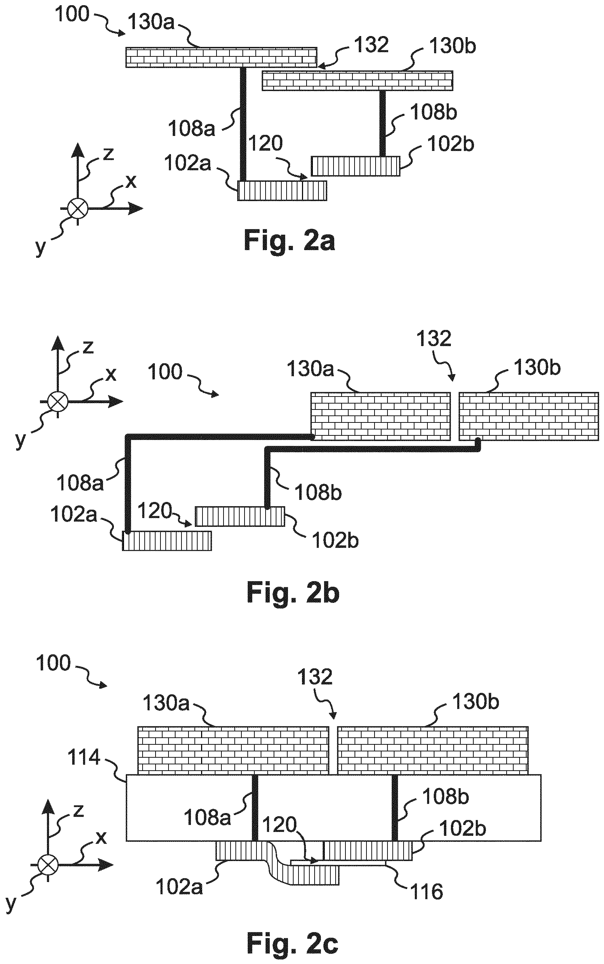

In the depicted embodiment, the electrodes 130a, 130b are coupled horizontally, i.e., at the smallest separation between the electrodes 130a, 130b, the surface normal of at least one of, or of each of the electrodes 130a, 130b is horizontal and points towards the other one of the electrodes 130a, 130b. In other embodiments (e.g., Fig. 2a), the electrodes 130a, 130b are coupled vertically.

A first interconnect 108a electrically connects the first superconductor layer 102a and the first electrode 130a.

A second interconnect 108b electrically connects the second superconductor layer 102b and the second electrode 130b.

Preferably, the electrodes 130a, 130b and the interconnects 108a, 108b are composed of respective superconductor materials, either of low-critical-temperature superconductor materials (e.g., elemental superconductors or their nitrides, such as Al, Nb, TiN) or of high-critical-temperature superconductor materials (e.g., anisotropic, layered superconductor materials as described above). Electrodes 130a, 130b and interconnects 108a, 108b made from low-critical-temperature superconductor materials facilitate a high-accuracy fabrication.

Fig. 2a gives a cross-sectional view of a qubit device 100 according to an embodiment similar to the one of Fig. 1.

However, in the embodiment of Fig. 2a, the electrodes 130a, 130b are coupled vertically, i.e., where the electrodes 130a, 130b exhibit their minimum separation, the surface normal of at least one of, or of each of the electrodes 130a, 130b is vertical and points towards the other one of the electrodes 130a, 130b.

Fig. 2b gives a cross-sectional view of a qubit device 100 according to an embodiment similar to the one of Fig. 1.

However, the interconnects 108a, 108b of Fig. 2b extend along the vertical and the horizontal directions, whereas the interconnects 108a, 108b of Fig. 1 extend along the vertical direction only.

Consequently, the interconnects 108a, 108b of Fig. 1 are shorter, which is beneficial in some applications. On the other hand, the electrodes 130a, 130b of Fig. 2a can be placed in a device layout independently of the superconductor layers 102a, 102b, which improves the design flexibility, which is beneficial in some applications.

Fig. 2c gives a cross-sectional view of a qubit device 100 according to an embodiment similar to the one of Fig. 1.

In the embodiment of Fig. 2c, an electrical insulation element 114 is arranged between the superconductor layers 102a, 102b and the electrodes 130a, 130b.

In particular, the electrical insulation element 114 ensures the electrical insulation of the electrode 130a from the superconductor layer 102b, and of the electrode 130b from the superconductor layer 102a.

The electrical insulation element 114 is composed of silicon, or a nitride, carbide, or oxide material. More specifically, it can be made from silicon carbide, silicon nitride, or amorphous silicon.

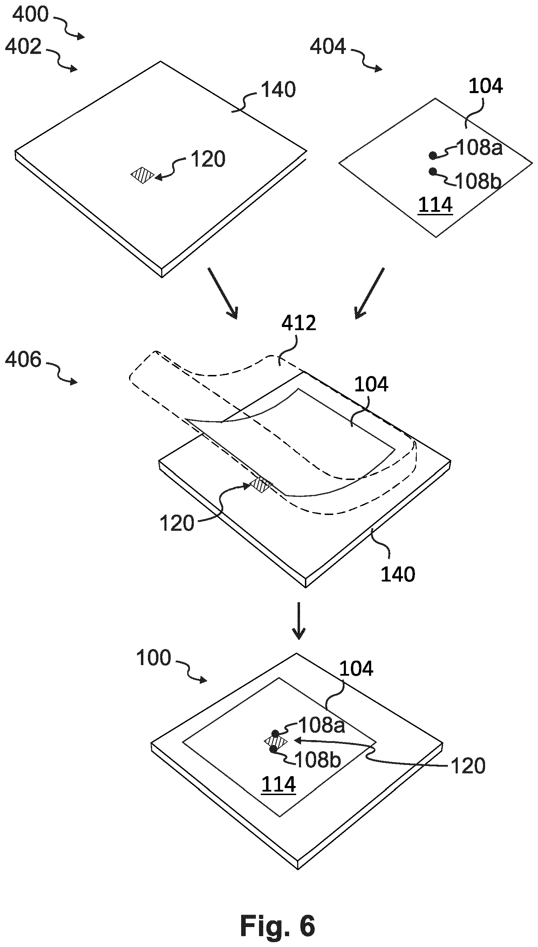

The electrical insulation element 114 is in some embodiments used to cap or seal the superconductor layers 102a, 102b, in particular, in combination with a substrate 140 which will be described below (Fig. 6). In such embodiments, the electrical insulation element 114 and the substrate 140 together enclose the superconductor layers 102a, 102b (arranged between the electrical insulation element 114 and the substrate 140) in a water-tight or moisture-tight or air-tight manner.

Moreover, in the embodiment of Fig. 2c, a spacer material 116 is provided between the first and the second superconductor layers 102a, 102b. The spacer material 116 ensures a suitable distance between the superconductor layers 102a, 102b to form the Josephson junction 120. In some embodiments, the spacer material 116 is composed of an anisotropic, layered material such as hexagonal boron nitride. The spacer material may as well be provided with the qubit device 100 according to any of the other embodiments.

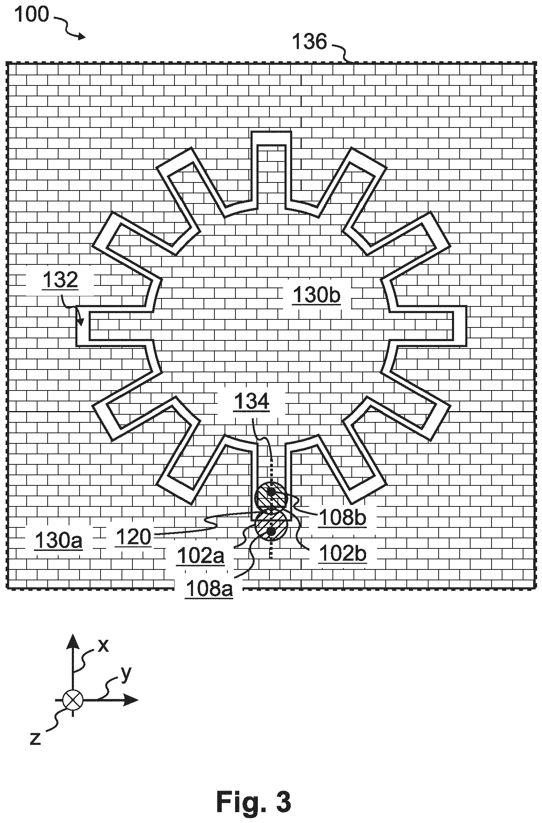

Fig. 3 gives a top view of a qubit device 100 according to some embodiments.

In a vertical (x-z) cross section along the line 134, the qubit device 100 of Fig. 3 is similar to the embodiment of Fig. 1 or Fig. 2c. In other words, Fig. 3 depicts a top view onto the qubit device 100 of Fig. 1 or Fig. 2c according to some embodiments.

Fig. 3 depicts a specific shape of the capacitor 132 in a horizontal x, y plane. Alternative shapes are possible. However, a capacitance of the capacitor 132 in a range from 70 to 400 femtofarads has proven beneficial.

The resulting capacitive energy *E_{C}* = *e*²/2*C,* where e is the electron charge, is smaller than the typical Josephson energy, *E_{J}*, of the Josephson junction 120 by a factor of 100 or more.

A region 136 is indicated in Fig. 3.

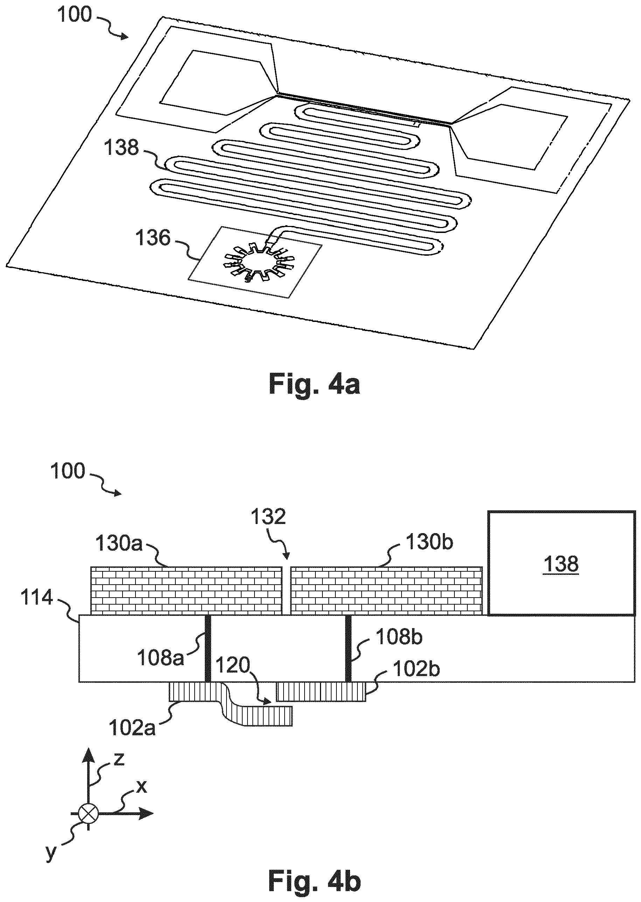

Fig. 4a, Fig. 4b depict a qubit device 100 according to another embodiment. Fig. 4a gives a perspective view. Therein, the region 136 corresponds to the region 136 of Fig. 3. Fig. 4b gives a cross-sectional view, more specifically, a vertical (x-z) cross section through the region 136 of Fig. 3, Fig. 4a according to the line 134 indicated in Fig. 3.

The qubit device 100 of Fig. 4a, Fig. 4b comprises a microwave resonator 138 capacitively coupled to the capacitor 132, i.e., to one of the electrodes 130a, 130b.

The resonance frequency of the microwave resonator 138 is in the range from 1 to 15 GHz.

The microwave resonator 138 is suitable for a dispersive readout of the qubit device 100.

The capacitor 132 and the microwave resonator 138 have thicknesses in the range from 40 to 80 nm.

The overall size (length and or width along the horizontal direction) of the qubit device 100, or of the electrical insulation element 114, respectively, is in the range from 0.5 to 1 mm.

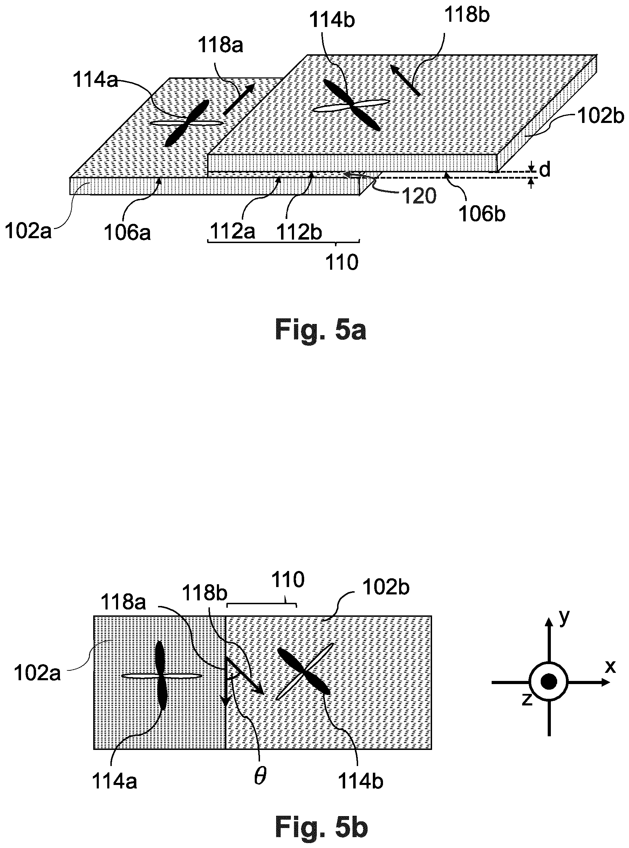

Fig. 5a, Fig. 5b illustrate, in detail, the second superconductor layer 102b arranged over the first superconductor layer 102a to form the Josephson junction 120. Fig. 5a gives a perspective view of the superconductor layers 102a, 102b and the Josephson junction 120, whereas Fig. 5b gives a top view. The detailed description of the superconductor layers 102a, 102b and the Josephson junction 120 of Fig. 5a, Fig. 5b applies as well to the superconductor layers 102a, 102b and the Josephson junctions 120 of the qubit devices 100 according to any of the various embodiments described above.

The first superconductor layer 102a and the second superconductor layer 102b overlap in a region 110. In other words, the region 110 forms an overlap region 110 (i.e., of the superconductor layers 102a, 102b). More specifically, in the overlap region 110, a first section 112a of a first surface 106a of the first superconductor layer 102a faces a second section 112b of a second surface 106b of the second superconductor layer 102b, and vice versa.

The superconductor layers 102a, 102b are separated by a distance d, specifically, in the overlap region 110.

The first superconductor material, i.e., the superconductor material of the first superconductor layer 102a, has a first orientation 118a. In Fig. 5a, Fig. 5b, the first orientation 118a is represented by an arrow 118a in a horizontal plane. In other words, the first orientation 118a is parallel to the first section 112a of the first surface 106a.

The second superconductor material, i.e., the superconductor material of the second superconductor layer 102b, has a corresponding second orientation 118b.

The orientations 118a, 118b can be defined by any or any combination of the following criteria:
According to a first definition, the orientations 118a, 118b correspond to primitive lattice vectors of the first/second superconductor material, such as respective in-plane primitive lattice vectors, or to projections of primitive lattice vectors of the respective (first/second) superconductor materials onto a horizontal plane, or onto the first surface 106a, or onto the second surface 106b, respectively.

Alternatively, the orientations 118a, 118b are defined by crystal facets of the first/second superconductor material.

The orientations 118a, 118b are alternatively defined by reciprocal lattice vectors of the first/second superconductor material, i.e., by in plane reciprocal lattice vectors or by projections of the reciprocal lattice vectors onto a horizontal plane, or onto the first surface 106a, or onto the second surface 106b, respectively.

Alternatively, the orientations 118a, 118b are defined by electronic orbitals 114a, 114b or by crystal momenta of a Bloch state of the first/second superconductor material. According to some embodiments, the first/second superconductor material is a d-wave superconductor, or a superconductor with a d-wave superconducting gap, respectively. In this case, the orientation 118a, 118b may be associated with a d-wave electronic spectrum, in particular with a d-wave nodal electronic spectrum 114a.

The first orientation 118a and the second orientation 118b are arranged at an angle θ, according to a predefined angle.

In particular, when the angle θ is in the range from 38 to 44.9°, the single-Cooper pair tunneling *E_{J}*, or the Josephson energy, *E_{J}*, respectively, is suppressed. The inventors have verified the finding of a suppressed Josephson energy *E_{J}* using simulations for BSCCO, and more specifically for Bi₂Sr₂CaCu₂O₈₊ₓ. It is similarly expected for other d-wave superconductors (or high-critical temperature superconductors, respectively, or superconductors comprising anisotropic, layered superconductor material, respectively) with an angle of approximately 90° between their primitive lattice vectors perpendicular to the axis c.

The Josephson energy is directly related to the critical current *I_{c}* of the Josephson junction as *E_{J}* = *I_{c}*Φ₀/2*π* where Φ₀ = *h*/2*e* is the flux quantum.

In this situation, two-Cooper pair tunneling is still possible, and the two-Cooper pair tunneling energy *Eₖ* is similar to the Josephson energy, *E_{J}*. The two-Cooper pair tunneling term can be written as *E_{K}*cos (2*φ*), forming a double-well potential. In preferred embodiments, the corresponding two lowest-energy eigenstates are used to provide the two-level system of the qubit device. The energy difference between the respective eigenstates of the two-level is small, i.e., within an energy/frequency difference of up to 2 GHz, and in some embodiments up to 1 GHz. The respective eigenstates are therefore referred to as quasi-degenerate.

The degeneracy does hand in hand with, and therefore indicates a situation in which dielectric losses and crosstalk between qubit devices (i.e., between the quantum-mechanical states of their respective two-level systems) are drastically reduced. Those dielectric losses and crosstalk are the main limitations of conventional transmon qubits. Thus, the relaxation time of the described qubit device is improved significantly as compared to the relaxation time in a conventional qubit device, e.g., of the transmon type. According to simulations performed by the inventors, the improvement amounts to a factor of 10.000, leading to coherence times up to 1 s.

Fig. 6 depicts a method 400 for fabricating the qubit device 100.

At step 402, a Josephson junction 120 between a first superconductor material and a second superconductor material is provided.

At step 404, a contact layer 104 is provided separate from the Josephson junction 120.

The contact layer 104 comprises an electrical insulation element 114, a first interconnect 108a, and a second interconnect 108b. The first interconnect 108a extends through the electrical insulation element 114. The second interconnect 108b extends through the electrical insulation element 114.

In some embodiments (not shown), the contact layer 104 is provided with additional, optional electrical elements arranged thereover, such as a capacitor 132 comprising a first electrode 130a and a second electrode 130b arranged over the electrical insulation element 114, or with a microwave resonator 138 arranged over the electrical insulation element 114. In some embodiments with the capacitor 132, the first interconnect 108a is connected to the first electrode 130a, and the second interconnect 108b is electrically connected to the second electrode 130b.

At step 406, the contact layer 104 is arranged over the Josephson junction 120 to form an electrical contact between the first interconnect 108a and the first superconductor material and to form an electrical contact between the second interconnect 108b and the second superconductor material.

In some embodiments, at step 402, a substrate 140 is provided 140.

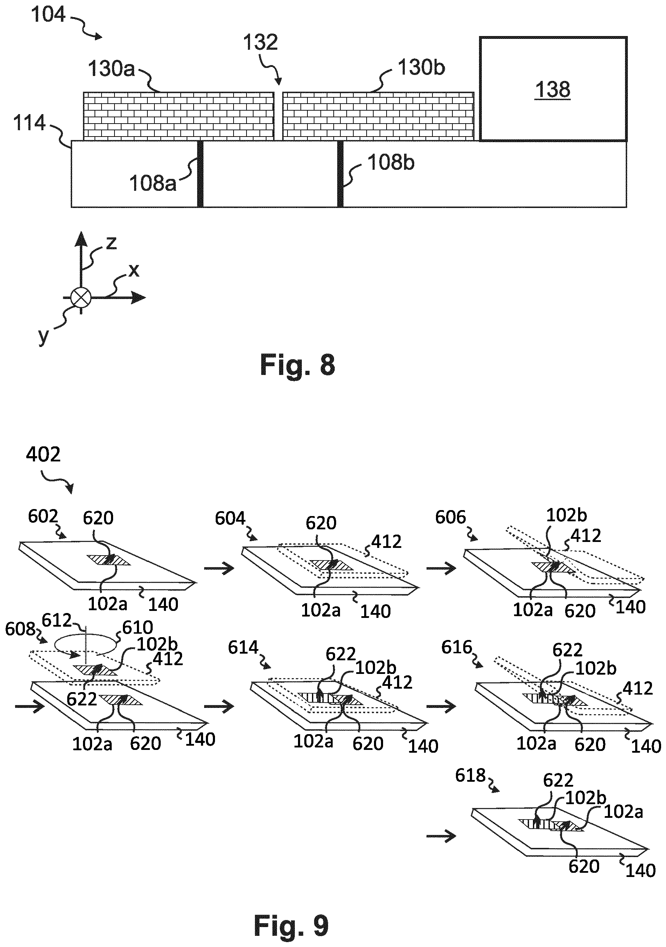

In some embodiments, at step 402, the first superconductor material (and/or the second) superconductor material is arranged above the substrate in the form of a first (and/or a second) superconductor layer 102a (102b). For this purpose, a pre-prepared first (and/or second) superconductor layer 102a (102b) is transferred onto the substrate 140, for example as described in detail in the context of Fig. 9. Alternatively, the first (or second) superconductor material may be deposited onto the substrate 140 (e. g. reactively) from a gas phase or using a vacuum deposition technique, such as chemical vapor deposition or molecular beam epitaxy.

In some embodiments, at step 406, the contact layer 104 is cooled with liquid-nitrogen to a temperature < -85°C (in other words, below a second temperature of -85°C) and arranged over the Josephson junction 120 while being at said low temperature. For this purpose, the contact layer 104 is arranged on a PDMS stamp 412 serving as a transfer device 412. Contact layer 104 and transfer device 412 are cooled 406 below the second temperature. Below the second temperature, the PDMS stamp 412 provides a strong adhesion to the contact layer 104.

Then, the PDMS stamp 412 and the contact layer 104 arranged thereon are positioned over and in physical contact with the substrate 140 and the Josephson junction 120 thereover. Thereby, the contact layer 104 is arranged 406 over the Josephson junction 120.

In an optional additional step, the PDMS stamp 412 is removed from the contact layer 104. For this purpose, the PDMS stamp 412 is heated to a temperature above the second temperature, and preferably to a temperature > -30°C. In other words, the PDMS stamp 412 is heated above the second temperature, and preferably above a third temperature of -30°C. This reduces the adhesion of the PDMS stamp 412. Consequently, the PDMS stamp may be removed, leaving the contact layer 104 arranged over the Josephson junction 120.

To avoid thermal damage to the first layer 102a, the temperature of the first layer 102a is kept below o°C (first temperature) while arranging the contact layer 104 thereover. This is achieved by keeping the temperature of the PDMS stamp 412 below the first temperature while the PDMS stamp 412 is in contact with the substrate 140 and/or with the Josephson junction 120.

The reduced adhesion of the PDMS stamp 412 at elevated temperature (as compared to the second temperature of -85°C) is related to the amorphous molecular structure of the PDMS with a glass transition temperature of around -100°C. Consequently, the third temperature is above the glass transition temperature of the PDMS. The second temperature amounts to at least the glass transition temperature of the PDMS. For temperatures above the glass transition temperature, the adhesion of elastic polymers decreases with increasing temperature. In other words, an alternative material may be used for the transfer device 412 instead of PDMS, in particular an elastic polymer for as long as its glass transition temperature is below the second temperature (and the third temperature).

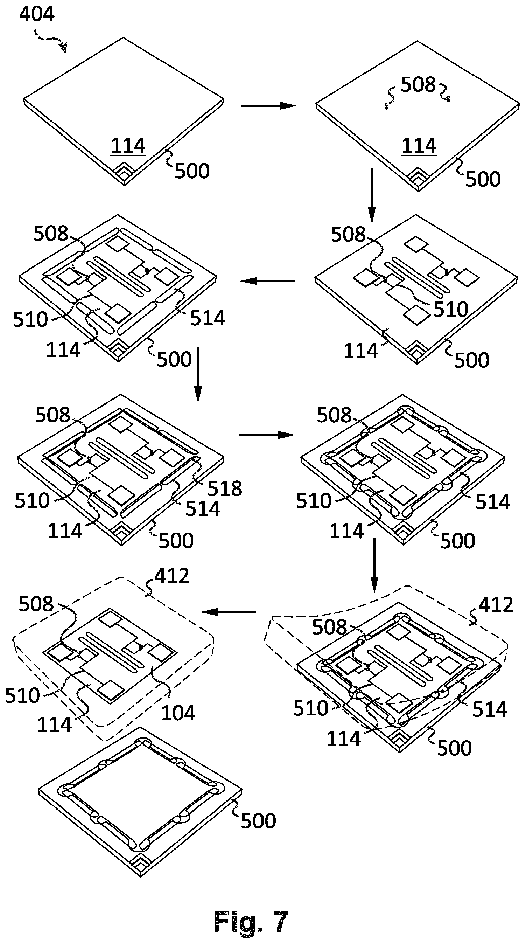

Fig. 7 gives details of the process step of providing 404 the contact layer 104 separately from the Josephson junction 120 according to an embodiment.

According to the depicted embodiment, an electrical insulation element 114 is provided by depositing a layer 114 of insulating material onto a second substrate 500 remote from the substrate 140.

Openings 508 are etched through the electrical insulation element 114.

A metallization layer 510 is deposited over and in the openings 508. Consequently, interconnects 108a, 108b are formed reaching down to a bottom surface of the electrical insulation element 114 through the openings 508.

According to some embodiments (not shown), the metallization layer 510 is also used to form additional electrical components above the electrical insulation element 114, such as a capacitor 132, or a first and second electrode 130a, 130b, respectively, and/or a microwave resonator 138.

A trench 514 is then formed in the electrical insulation element 114. The trench 514 reaches down to the bottom surface of the electrical insulation element 114, or cuts through the electrical insulation element 114, respectively. The trench 514 is laterally interrupted by sections of insulation material of the electrical insulation element 114 serving as anchor points (teathers).

A deeper (than the trench 514) trench 518 is then formed, reaching into the second substrate 500 and/or into an optional sacrificial layer (not shown) between the second substrate 500 and the electrical insulation element 114. In other words, if a distinct sacrificial layer is absent, a (top) sacrificial portion of the second substrate 500 serves as the sacrificial layer.

An isotropic etch is then performed to remove the sacrificial layer and/or the sacrificial portion of the second substrate 500 below the electrical insulation element 114 in the lateral region within the deeper trench 518. Consequently, the resulting contact layer 104 is free-standing with respect to the second substrate 500. The resulting contact layer 104 is mechanically flexible, for as long as the electrical insulation element 114 is thin enough. A thickness of the electrical insulation element 114 in the range from 300 to 600 nm has proven beneficial for this purpose.

Prior to or after the isotropic etch, the PDMS stamp 412 is attached to (transferred onto) the electrical insulation element 114 with the openings 508 (which may be entirely filled with the metallization layer 510 at this point). The PDMS stamp 412 is cooled to a temperature below the second temperature; the cooling may be performed before or after transferring the PDMS a stamp 412 onto the electrical insulation element 114 with the openings 508.

The cooled PDMS stamp 412 is removed from the second substrate 500 while being cooled. The PDMS cooled below the second temperature provides a strong adhesion. Consequently, removing the PDMS stamp 412 from the second substrate 500 lifts the contact layer 104 off from the second substrate 500 as the contact layer 104 adheres strongly to the PDMS stamp 412.

Consequently, the contact layer 104 remains arranged on the PDMS stamp 412 and is separated from the substrate 500, as illustrated in the last panel of Fig. 7.

Optionally, the contact layer 104 is cleaned at its bottom surface (facing away from the PDMS stamp 412), using, for example a wet and/or dry cleaning step such as etching, ion-milling. If applied, the cleaning step is preferably performed just before arranging the contact layer 104 over the substrate 140.

Fig. 8 depicts a contact layer 104 as used in the method 400 of Fig. 6 and obtained by the method 404 of Fig. 7.

The contact layer 104 of Fig. 8 is formed with the optional capacitor 132 and with the optional microwave resonator 138. A top view of the contact layer 104 corresponds to the top view of Fig. 3 (yet, without the Josephson junction 120 and the first and second superconductor layer 102a, 102b), and a perspective view of the contact layer 104 corresponds to the perspective view of Fig. 4.

In alternative embodiments (not shown, see description in the context of Fig. 7), the contact layer 104 is formed without the capacitor 132 and/or without the microwave resonator 138.

Fig. 9 illustrates, according to an embodiment, process steps for providing 402 the Josephson junction 120 between the first superconductor material and the second superconductor material.

The method is optionally applied in the method of Fig. 6 to extend or replace the process steps 402 thereof.

At step 602, a superconductor material is provided in the form of a superconductor layer 102a above a substrate 140. The superconductor material is an anisotropic, layered material.

The anisotropic, layered material of the superconductor layer 102a has a crystallographic orientation 620. The crystallographic orientation 620 corresponds to a direction parallel to the covalently bound atomic layers 126, or to the van der Waals gaps 128, respectively, as described in the context of Fig. 1. For example, the crystallographic orientation 620 corresponds to a primitive lattice vector parallel to the covalently bound atomic layers 126, or parallel to the van der Waals gaps 128, respectively, or to a projection of a primitive lattice vector of the anisotropic, layered material onto the covalently bound atomic layers 126, or onto the van der Waals gaps 128, respectively.

At step 604, a transfer device 412 in the form of a PDMS stamp 412 is attached to (transferred onto) the superconductor layer 102a and the substrate 140, as similarly described for the attachment of the PDMS stamp 412 of Fig. 7 to the electrical insulation element 114.

The PDMS stamp 412 is cooled to a temperature below the second temperature described above; the cooling may be performed before or after transferring the PDMS stamp 412 onto the superconductor layer 102a and the substrate 140.

At step 606, the cooled PDMS stamp 412 is removed from the substrate 140 while being cooled. The PDMS cooled below the second temperature provides a strong adhesion. Consequently, when the PDMS stamp 412 is removed from the substrate 140, a portion of the superconductor layer 102a adheres to the PDMS stamp 412. Another portion of the superconductor layer 102a is left behind on the substrate 140. In other words, the superconductor layer 102a is cleaved.

The cleaving of anisotropic, layered material, and hence of the superconductor layer 102a, typically takes place along the van der Waals gaps 128 between the covalently bound atomic layers 126 of the anisotropic, layered material. Consequently, the surfaces of the superconductor layers 102a, 102b freshly prepared by the cleaving are parallel to covalently bound atomic layers 126, and/or to a crystallographic plane of the layered material, respectively.

At step 608, the portion of the superconductor layer 102a left behind on the substrate 140 forms the first superconductor layer 102a. In the following, only this left-behind superconductor layer 102a will be referred to as the first superconductor layer 102a.

The portion of the superconductor layer 102a adhering to the PDMS stamp 412 forms the second superconductor layer 102b. According to the depicted embodiment, the second superconductor layer 102b is composed of the same material as the first superconductor layer 102a. However, a second superconductor layer 102b composed of a different superconductor material can be provided by applying the processes described above in the context of steps 602, 604, 606 to the different superconductor material. The portion of the different superconductor material adhering to the respective PDMS stamp thereafter is then used as the second superconductor layer 102b.

Still referring to step 608, the PDMS stamp 412 with the second superconductor layer 102b adhering thereto is then orientated and positioned with respect to the substrate 104 and the first superconductor layer 102a.

According to the depicted embodiment, the positioning and orientating involves a rotation 610 around an axis 612 perpendicular to the second superconductor layer 102b to rotate (twist) the crystallographic orientation 622 of the second superconductor layer 102b with respect to the crystallographic orientation 620 of the first superconductor layer 102a.

Referring to step 614, the PDMS stamp 412 with the second superconductor layer 102b adhering thereto is transferred onto the first superconductor layer 102a and the substrate 140 according to the position and orientation described in the context of step 608.

In particular, the PDMS stamp 412 is transferred onto the substrate 140 such that the first superconductor layer 102a and the second superconductor layer 102b overlap to form the overlap region 110 and/or the Josephson junction 120 described above.

Referring to step 616, the PDMS stamp 412 is heated to a temperature exceeding the second temperature, and preferably exceeding the third temperature described above, to reduce the adhesion of the PDMS stamp 412.

The PDMS stamp 412 is then removed from the substrate 140.

Due to the reduced adhesion of the PDMS at the elevated temperature exceeding the second and preferably the third temperature, the PDMS stamp 412 releases the first superconductor layer 102a and the second superconductor layer 102b. The first superconductor layer 102a and the second superconductor layer 102b are left behind on the substrate 140.

At step 618, the provision 402 of the Josephson junction 120 is completed.

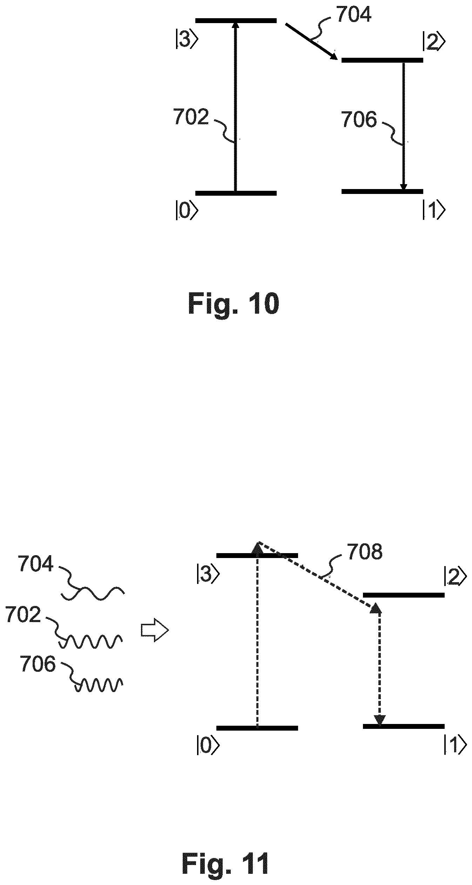

Fig. 10, Fig. 11 illustrate two different embodiments of a method for changing a state of the qubit device 100.

Before going into the details of the individual embodiments, features common to both embodiments are described.

In general, a qubit implements a quantum mechanical two-level system. Ideally, the quantum-mechanical two-level system would provide exactly two distinguishable quantum states. In practice, the quantum-mechanical two-level system typically has a higher number of distinguishable quantum states.

The qubit device 100 implements a respective quantum mechanical two-level system.

In Fig. 10, Fig. 11, four quantum states of the quantum mechanical two-level system, or of the qubit device 100, respectively, are depicted: the ground state |0>, the first excited state |1>, the second excited state |2>, and the third excited state |3>.

A target state of the qubit device 100 refers to a superposition of the ground state |0> and the first excited state |1>.

To change the state of the qubit device, microwaves 702, 704, 706 with three different frequencies are coupled to the qubit device 100.

The first microwave frequency of the first microwave 702 is associated with an energy difference between the third excited state |3> and the ground state |0>. The first microwave frequency is in a range from 7 GHz to 15 GHz.

The second microwave frequency of the second microwave 704 is associated with an energy difference between the third excited state |3> and the second excited state |2>. The second microwave frequency is in a range from 1 GHz to 2 GHz.

The third microwave frequency of the third microwave 706 is associated with an energy difference between the second excited state |2> and the first excited state |1>. The third microwave frequency is in a range from 6 GHz to 13 GHz.

The microwaves 702, 704, 706 drive a transition of the quantum-mechanical two-level system, for example, from the ground state |0> to a superposition of the ground state |0> and the first excited state |1>. The transition occurs via coupling to the second excited state |2> and to the third excited state |3>, either resonantly (Fig. 10) or non-resonantly (Fig. 11).

After changing the state of the quantum mechanical two-level system, or of the qubit device 100, respectively, the changed state is analyzed using a dispersive readout, e.g., using the microwave resonator 138 described above.

Fig. 10 shows a resonant transition. In this case, at least one, at least two, or all of the first, second and third microwave frequencies are matched to the respective energy differences, e.g., within 0.01% of the respective energy differences.

In the embodiment of Fig. 10, the first microwave 702 and the third microwave 706 are first coupled to the qubit device as pi-pulses, thus transferring the occupation and the phase of the ground state |0> and the first excited state |1> to the second excited state |2> and to the third excited state |3>. Thereafter, the second microwave 704 is coupled to the qubit device as a control pulse, to define a superposition of the second excited state |2> and the third excited state |3> as required by the application using the qubit device. Thereafter, the first microwave 702 and the third microwave 706 are coupled to the qubit device as pi-pulses, thus transferring the superposition of the second excited state |2> and the third excited state |3> to the ground state |0> and to the first excited state |1>.

Fig. 11 shows a non-resonant transition 708. In this case, at least one, at least two, or all of the first, second and third microwave frequencies are mismatched to the respective energy differences, e.g., by at least 0.01% and/or by at most 5% of the respective energy differences. In corresponding embodiments, the microwaves 702, 704, 706 are coupled to the qubit device 100 synchronously. The induced transitions generally correspond to the ones of the resonant case, but in a single non-resonant, Raman-type multi-photon transition. Intensities of the microwaves 702, 704, 706 are generally higher in the non-resonant case of Fig. 11 than in the resonant case of Fig. 10.

### LIST OF REFERENCE SIGNS

- 100: qubit device
- 102a, 102b: first, second superconductor layer
- 126: covalently bound atomic layers
- 128: van der Waals gaps
- c: c-axis
- 120: Josephson junction
- 132: capacitor
- 130a, 130b: first, second electrode
- 124: region
- 124': close-up of region 124
- 108a, 108b: first, second interconnect
- 2B: first fixation element
- 114: electrical insulation element
- 140: substrate
- 118a, 118b: first, second orientation parallel to covalently bound atomic layers
- 114a, 114b: electronic d orbitals
- 106a, 116b: surfaces of first, second superconductor material
- 110: overlap region
- 112a, 112b: surfaces of first, second superconductor material opposite to each other at the Josephson junction/in the overlap region
- d: distance between first and second superconductor material at the Josephson junction
- 134: line/plane
- 136: region
- 138: microwave resonator
- 412: transfer device, PDMS stamp
- 602: providing a first superconductor material over the substrate
- 604: attaching PDMS stamp to substrate with first superconductor material
- 606: cleaving first superconductor material to generate first superconductor layer and first superconductor layer
- 608: alignment and positioning of second superconductor layer arranged on PDMS stamp
- 610: rotation
- 612: axis
- 614: attaching PDMS stamp and second superconductor layer arranged thereon to substrate with first superconductor layer
- 616: removing PDMS stamp
- 618: substrate with first and second superconductor layer
- 620, 622: crystallographic orientations of the first, second superconductor material
- 702, 704, 706: first, second, third microwave
- 708: non-resonant/Raman transition

## Claims

1. A qubit device (100), comprising:
a first superconductor layer (102a), comprising a first superconductor material, wherein the first superconductor material is a first anisotropic, layered material with covalently bound atomic layers (126) and a first c-axis perpendicular to the covalently bound atomic layers (126) of the first superconductor material;
a second superconductor layer (102b), comprising a second superconductor material, wherein the second superconductor material is a second anisotropic, layered material with covalently bound atomic layers (126) and a second c-axis perpendicular to the covalently bound atomic layers (126) of the second superconductor material;
wherein the second superconductor layer (102b) is arranged over the first superconductor layer (102a) to form a Josephson junction (120) between the first superconductor material and the second superconductor material;
wherein the first c-axis and the second c-axis are aligned with each other at the Josephson junction (120); and
wherein the aligned first and second c-axes at the Josephson junction (120) intersect both the first superconductor layer (102a) and the second superconductor layer (102b);
wherein the qubit device (100) further comprises:
a capacitor (132) comprising a first electrode (130a) and a second electrode (130b);
a first interconnect (108a) electrically connecting the first electrode (130a) and the first superconductor layer (102a); and
a second interconnect (108b) electrically connecting the second electrode (130b) and the second superconductor layer (102b); and
wherein the capacitor (132) is arranged at a vertical position exceeding the vertical positions of both the first superconductor layer (102a) and the second superconductor layer (102b).

2. The qubit device (100) of claim 1, further comprising an electrical insulation element (114),
wherein the electrical insulation element (114) is arranged at a vertical position between the vertical position of the capacitor (132) and the vertical position(s) of the first superconductor layer (102a) and/or of the second superconductor layer (102b); and/or
wherein the electrical insulation element (114) is arranged between the first superconductor layer (102a) and the first electrode (130a); and/or
wherein the electrical insulation element (114) is arranged between the second superconductor layer (102b) and the second electrode (130b); and/or
wherein at least a section of the first interconnect (108a) is arranged in the electrical insulation element (114); and/or
the first interconnect (108a) is arranged in the electrical insulation element (114); and/or
wherein at least a section of the second interconnect (108b) is arranged in the electrical insulation element (114); and/or
the second interconnect (108b) is arranged in the electrical insulation element (114); and/or
wherein the first interconnect (108a) and/or the second interconnect (108b) extend(s) through the electrical insulation element (114), and, optionally, from a bottom surface thereof to a top surface thereof; and/or
wherein the electrical insulation element (114) comprises or is composed of silicon carbide, silicon nitride, or amorphous silicon; and/or
wherein a lateral extension of the electrical insulation element (114) fully covers a lateral extension of the first superconductor layer (102a) and a lateral extension of the second superconductor layer (102b); and/or
wherein the electrical insulation element (114) has a thickness along the vertical direction in a range from 300 nm to 600 nm.

3. The qubit device (100) of claim 2, which further comprises an encapsulation of the Josephson junction (120), such as a water-tight, a moisture-tight, an oxygen-tight and/or an air-tight encapsulation, wherein the encapsulation comprises the electrical insulation element (114) and, optionally, a substrate (140) over which the Josephson junction (120) is arranged.

4. The qubit device (100) of any of the preceding claims, wherein the first superconductor material comprises a first orientation (118a, 620) parallel to its covalently bound atomic layers (126) and the second superconductor material comprises a second orientation (118b, 622) parallel to its covalently bound atomic layers (126), and wherein the first superconductor material and the second superconductor material at the Josephson junction (120) are arranged with an angle (θ) between the first orientation (118a, 620) and the second orientation (118b, 622) corresponding to a predefined angle.

5. The qubit device (100) of claim 4,
wherein the first superconductor material and the second superconductor material at the Josephson junction (120) are arranged with an angle (θ) between the first orientation (118a, 620) and the second orientation (118b, 622) in a range from 38 to 44.9°; and/or
wherein the first c-axis corresponds to a primitive lattice vector of the first superconductor material and the second c-axis corresponds to a primitive lattice vector of the second superconductor material; and/or
wherein the first orientation (118a, 620) corresponds to a first primitive lattice vector perpendicular to the first c-axis in particular, to a direction of the first primitive lattice vector perpendicular to the first c-axis; and/or
wherein the second orientation (118b, 622) corresponds to a second primitive lattice vector perpendicular to the second c-axis, in particular, to a direction of the second primitive lattice vector perpendicular to the first c-axis; and/or
wherein the covalently bound atomic layers (126) of the first superconductor material and/or of the second superconductor material are separated by van der Waals gaps (128); and/or
wherein the first orientation (118a, 620) corresponds to a lattice vector of the first superconductor material parallel to the covalently bound atomic layers (126) of the first superconductor material, and the second orientation (118b, 622) corresponds to a corresponding lattice vector of the second superconductor material parallel to the covalently bound atomic layers (126) of the second superconductor material; wherein, optionally, the first superconductor material and the second superconductor material have a same crystallographic structure and/or a same crystallographic unit cell and/or are a same superconductor material.

6. The qubit device (100) of any of the preceding claims,
wherein the first superconductor material and/or the second superconductor material is a high-temperature superconductor material, in particular, with a critical temperature of at least 4 K or at least 8 K or at least 15 K or at least 30 K or at least 50 K or at least 70 K or at least 78 K; and/or
wherein the first superconductor material and/or the second superconductor material is a type-II superconductor material; and/or
wherein the first superconductor material and/or the second superconductor material is a d-wave superconductor material; and/or
wherein the first superconductor material and/or the second superconductor material comprises oxygen or a chalcogenide, in particular to at least 20 atomic percent or at least 30 atomic percent; and/or
wherein the first superconductor material and/or the second superconductor material comprises a chemical composition Bi₂Sr₂Caₙ₋₁CuₙO₂ₙ₊₄₊ₓ, in particular, wherein n = 1 or 2 or 3 or 4.

7. The qubit device (100) of any of the preceding claims, which further comprises a microwave resonator (138);
wherein, optionally, the microwave resonator (138) is capacitively coupled to the capacitor (132), optionally, along a horizontal direction; and/or
wherein, optionally, the microwave resonator (138) is arranged at a vertical position exceeding the vertical positions of both the first superconductor layer (102a) and the second superconductor layer (102b); and/or
wherein, optionally, the microwave resonator (138) comprises or is composed of a superconductor material, such as a low-temperature superconductor material or an elemental or nitride superconductor material, such as Al, Nb, NbN, or TiN; and/or
wherein, optionally, a resonance frequency of the microwave resonator (138) is in a range from 1 GHz to 15 GHz.

8. The qubit device (100) of any of the preceding claims, wherein the first electrode (130a) and/or the second electrode (130b) and/or the first interconnect (108a) and/or the second interconnect (108b) comprises or is composed of a superconductor material, such as a low-temperature superconductor material or an elemental or nitride superconductor material, such as Al, Nb, NbN, or TiN.

9. A method (400) for fabricating a qubit device (100), the method comprising:
providing (402) a Josephson junction (120) between a first superconductor material and a second superconductor material;
providing (404) a contact layer (104) separate from the Josephson junction (120), wherein the contact layer (104) comprises:
an electrical insulation element (114);
a first interconnect (108a) extending through the electrical insulation element (114); and
a second interconnect (108b) extending through the electrical insulation element (114); and
arranging (406) the contact layer (104) over the Josephson junction (120) to form an electrical contact between the first interconnect (108a) and the first superconductor material and to form an electrical contact between the second interconnect (108b) and the second superconductor material.

10. The method of claim 9, which further comprises cooling the Josephson junction (120) to a temperature below a first temperature while the contact layer (104) is arranged over the Josephson junction (120), wherein the first temperature is o°C, or 250 K, or 230 K, or 210 K, or 190 K, or 170 K, or 150 K, or 130 K.

11. The method of any of claims 9 or 10, wherein the arranging the contact layer (104) over the Josephson junction (120) comprises:
attaching a transfer device (412) to the contact layer (104); and
cooling the transfer device (412) to a temperature below a second temperature to attach the transfer device (412) to the contact layer (104);
wherein the transfer device (412) is adapted to provide a strong adhesion when a temperature of the transfer device (412) is below the second temperature and to provide a weak adhesion when the temperature of the transfer device (412) is above the second temperature; and/or
wherein the transfer device (412) comprises or is composed of an elastomer, wherein, optionally, the second temperature corresponds to a glass transition temperature of the elastomer and/or the elastomer is PTFE or PDMS; and/or
wherein the second temperature is no larger than the first temperature.

12. The method of claim 11, wherein the arranging the contact layer (104) over the Josephson junction (120) comprises releasing the transfer device (412) from the contact layer (104), wherein the releasing the transfer device (412) from the contact layer (104) comprises heating the transfer device (412) to a temperature between the second temperature and the first temperature.

13. The method of any of claims 9 to 12,
wherein the first superconductor material is a first anisotropic, layered material with covalently bound atomic layers (126) and a first c-axes perpendicular to the covalently bound atomic layers (126) of the first superconductor material;
wherein the second superconductor material is a second anisotropic, layered material with covalently bound atomic layers (126) and a second c-axes perpendicular to the covalently bound atomic layers (126) of the second superconductor material; and
wherein the Josephson junction (120) is provided such that the first c-axis and the second c-axis aligned with each other at the Josephson junction (120), and/or such that both the first and second c-axes at the Josephson junction (120) intersect both the first superconductor material and the second superconductor material.

14. The method of claim 13, wherein the providing the Josephson junction (120) between the first superconductor material and the second superconductor material comprises:
arranging a first superconductor layer (102a) of the first anisotropic, layered material over a substrate (140); and
arranging a second superconductor layer (102b) of the second anisotropic, layered material over the first superconductor layer (102a) to generate the Josephson junction (120);
optionally, prior to the arranging the first superconductor layer (102a) and the second superconductor layer (102b):
cleaving the first anisotropic, layered material to generate the first superconductor layer (102a), and, optionally, keeping the first anisotropic, layered material at a temperature below the first temperature while cleaving it; and/or
cleaving the second anisotropic, layered material to generate the second superconductor layer (102b), and, optionally, keeping the second anisotropic, layered material at a temperature below the first temperature while cleaving it;
wherein, optionally, the cleaving the first anisotropic, layered material and/or the cleaving the second anisotropic, layered material and/or the arranging the first superconductor layer (102a) over the substrate (140) and/or the arranging the second superconductor layer (102b) over the first superconductor layer (102a) is/are performed using a transfer device (412) comprising or composed of an elastomer.

15. A contact layer (104) for fabricating a qubit device (100), the contact layer (104) comprising:
an electrical insulation element (114);
a capacitor (132) comprising a first electrode (130a) and a second electrode (130b) arranged over the electrical insulation element (114);
a first interconnect (108a) electrically connected to the first electrode (130a) and extending through the electrical insulation element (114) from a bottom surface thereof to a top surface thereof; and
a second interconnect (108b) electrically connected to the second electrode (130b) and extending through the electrical insulation element (114) from the bottom surface thereof to the top surface thereof;
wherein each of the first electrode (130a), the second electrode (130b), the first interconnect (108a), and the second interconnect (108b) comprises a respective superconductor material.
